# EUROPÄISCHE PATENTSCHRIFT

(11) **EP 2 577 762 B1**
(45) Veröffentlichungstag und Bekanntmachung des Hinweises auf die Patenterteilung: **25.11.2015**
(21) Anmeldenummer: 11723085.4
(22) Anmeldetag: 06.06.2011
(51) Int. Cl.: H01L 41/273, H01L 41/293, H01L 41/083

(54) **VERFAHREN ZUM HERSTELLEN EINES PIEZOAKTORS UND PIEZOAKTOR**
METHOD FOR PRODUCING A PIEZO ACTUATOR AND PIEZO ACTUATOR
PROCÉDÉ DE FABRICATION D'UN ACTIONNEUR PIÉZOÉLECTRIQUE ET ACTIONNEUR PIÉZOÉLECTRIQUE

(30) Priorität: 07.06.2010 DE 102010022911
(43) Veröffentlichungstag der Anmeldung: 10.04.2013
(73) Patentinhaber: Continental Automotive GmbH, 30165 Hannover (DE)
(72) Erfinder: BENKERT, Katrin, 90571 Schwaig (DE); BÖDINGER, Hermann, 81243 München (DE); DENNELER, Stefan, 81371 München (DE); KASTL, Harald Johannes, 95686 Fichtelberg (DE); LENK, Andreas, 01728 Bannewitz Ot Possendorf (DE); SCHUH, Carsten, 85598 Baldham (DE)
(86) Internationale Anmeldenummer: PCT/EP2011/059285
(87) Internationale Veröffentlichungsnummer: WO 2011/154352

(56) Entgegenhaltungen:
- EP-A1- 0 766 325
- WO-A1-2008/119702
- WO-A2-2008/092740
- DE-A1- 10 260 853
- DE-A1-102006 011 293
- US-A- 5 254 212

## Beschreibung

Die Erfindung betrifft ein Verfahren zum Herstellen eines Piezoaktors sowie einen Piezoaktor.

Ein Bauelement aus übereinander gestapelten Piezoelementen wird als (Piezo-)Stapel bezeichnet. Die Funktion eines Piezoelements beruht auf der Deformation eines piezokeramischen Materials, wie z.B. Blei-Zirkonat-Titanat, und der Einwirkung eines elektrischen Feldes. Wird an ein Piezoelement eine elektrische Spannung angelegt, so dehnt sich dieses in senkrechter Richtung zum von der elektrischen Spannung erzeugten elektrischen Feld aus. Ein einzelnes Piezoelement weist einen relativ kleinen Stellweg auf, weswegen für einen größeren Stellweg ein Piezostapel aus mehreren abwechselnd aufeinander folgenden piezoelektrischen Schichten und sog. Innenelektrodenschichten verwendet wird.

Die Innenelektrodenschichten sind üblicherweise abwechselnd mit an gegenüberliegenden Außenflächen des Piezostapels angeordneten Außenelektroden elektrisch verbunden. Die Innenelektrodenschichten, die mit einer der beiden Außenelektroden elektrisch verbunden sind, sind daher bis zu der Außenseite, an der diese Außenelektrode angeordnet ist, für die elektrische Verbindung mit der Außenelektrode herangeführt. Damit die Innenelektrodenschichten von der anderen Außenelektrode elektrisch isoliert sind, reichen die Innenelektrodenschichten nicht bis zu der Außenseite des Piezostapels heran, an der die weitere Außenelektrode angeordnet ist. In diesen Bereichen sind die Innenelektrodenschichten von der Außenseite zurückgesetzt. Dies wird beispielsweise dadurch erreicht, dass der Piezostapel in diesen Bereichen mit Silikonharz, Kunststoff oder Lacken gefüllten Schlitzen versehen ist.

Durch die zurückgesetzten Innenelektrodenschichten ergeben sich in den diesen Bereichen zugeordneten piezoelektrischen Schichten sog. inaktive Zonen, die bei einer an den Außenelektroden- bzw. Innenelektrodenschichten angelegten elektrischen Spannung von einer reduzierten elektrischen Feldstärke durchsetzt werden und sich daher bei angelegter elektrischer Spannung weniger stark dehnen als die übrigen sog. aktiven Zonen der piezoelektrischen Schichten. Dies führt zu mechanischen Spannungen, insbesondere in den inaktiven Zonen und den Randbereichen zu den inaktiven Zonen und kann zu sog. Polungsrissen in den inaktiven und aktiven Zonen der piezoelektrischen Schichten sowie in den Außenelektroden führen. Die Gefahr von Polungsrissen ist dabei umso größer, je größer die inaktiven Zonen sind.

Um einen Piezoaktor mit einem Piezostapel bereitstellen zu können, bei dem möglichst kleine inaktive Zonen ausgebildet sind, schlägt die DE 10 2006 011 293 A1 ein Verfahren vor, das darauf basiert, einen vollaktiven Grünstapel weiter zu verarbeiten.

Als vollaktiver Grünstapel (bzw. vollaktiver Piezostapel) wird ein aus mehreren Grünfolien (piezoelektrischen Schichten) und dazwischen angeordneten elektrisch leitenden Schichten gebildeter Grünstapel (Piezostapel) bezeichnet, bei dem die elektrisch leitenden Schichten die Innenelektrodenschichten des Stapels bilden und bis zu den Außenseiten des Stapels durchgehend ausgebildet sind. Ein solcher vollaktiver Grünstapel (Piezostapel) hat demnach keine inaktiven, sondern ausschließlich aktive Zonen, d.h. eine zwischen zwei Innenelektrodenschichten angeordnete Grünfolie (piezoelektrische Schicht) des vollaktiven Grünstapels (Piezostapels) wird auf ihrer einen Seite von der einen Innenelektrodenschicht und auf ihrer anderen Seite von der anderen Innenelektrodenschicht komplett abgedeckt. Ein Vorteil eines solchen vollaktiven Piezostapels ist dessen relativ einfache Herstellung mittels bekannter Prozessschritte.

Die Innenelektrodenschichten sind dafür vorgesehen, abwechselnd mit an der Außenseite eines aus dem Grünstapel erzeugten Piezostapels anzuordnenden Außenelektroden elektrisch verbunden zu werden. Damit die Innenelektrodenschichten jedoch nur mit der für sie vorgesehenen Außenelektrode elektrisch verbunden werden und von der anderen Außenelektrode elektrisch isoliert bleiben, werden die Bereiche der Außenseite, an der die weitere Außenelektrode später angeordnet wird, mit Gräben versehen. Durch die Gräben werden die Innenelektrodenschichten in diesen Bereichen von der jeweiligen Außenseite des vollaktiven Grünstapels zurückversetzt, wodurch in diesen Bereichen kleinste inaktive Zonen entstehen. Damit beim späteren Anbringen der Außenelektroden die Innenelektrodenschichten auch nur mit der vorgesehenen Außenelektrode elektrisch verbunden werden, werden die Gräben vor dem Anbringen der Außenelektroden mit dem elektrisch isolierenden Schlicker, einem flüssigen Gemisch aus Keramikpulver und Bindern, gefüllt.

Mit dem in der DE 10 2006 011 293 A1 vorgeschlagenen Verfahren können die Gräben und somit die inaktiven Zonen des mit den Gräben versehenen Piezostapels derart dimensioniert werden, dass sie nicht größer sind, als es unbedingt für eine gute elektrische Isolierung der Innenelektrodenschichten zur entsprechenden Außenelektrode notwendig ist. Dadurch können die inaktiven Zonen dieses Piezostapels kleinst ausgeführt werden, wodurch die Gefahr der Entstehung von Polungsrissen vermindert wird.

Zur Herstellung der Gräben schlägt die DE 10 2006 011 293 A1 vor, einen Laser zu verwenden. Ein Nachteil dieses Vorgehens besteht darin, dass durch Lasern der Gräben in diesen Bereichen die Organik im Grünstack verbrennt. Dabei kann die Keramik teilweise zersetzt werden unter Bildung von refraktären Primäroxiden wie ZrO₂ und TiO₂. Das abgebrannte Material muss anschließend vollständig aus den Gräben entfernt werden, um ein poren- und rissfreies Verfüllen der Gräben zu gewährleisten. Dies ist mit lediglich hohem Aufwand möglich, wobei gleichzeitig die Gefahr der Schädigung des Piezostapels hoch ist.

Um den Schlicker in die Gräben einzubringen schlägt die DE 10 2006 011 293 A1 vor, ebenfalls auf das zum Erstellen der Gräben verwendete Laserverfahren zurückzugreifen. Ein Nachteil dieser Vorgehensweise besteht darin, dass das Verfahren relativ zeitaufwändig und kostenintensiv ist, da die Herstellung der Gräben durch den Laser sequentiell zu erfolgen hat.

DE 10 2006 011 293 A1 betrifft einen Piezoaktor und Verfahren zum Herstellen eines Piezoaktors mit einem Piezostapel und zwei an der Außenseite des Piezostapels angeordneten Außenelektroden. Zunächst wird ein vollaktiver Piezostapel aus mehreren abwechselnd aufeinanderfolgenden piezoelektrischen Schichten und durchgehenden Innenelektrodenschichten bereit gestellt. Die Außenseite des vollaktiven Piezostapels wird mit Gräben in Bereichen versehen, in denen die Innenelektrodenschichten von den Außenelektroden elektrisch isoliert sein sollen, sodass die Gräben die Innenelektrodenschichten in diesen Bereichen von der Außenseite des Piezostapels nach innen verkürzen. Die Gräben werden anschließend mit einem elektrisch isolierenden Material gefüllt und die beiden Außenelektroden werden auf die Außenseite des Piezostapels aufgebracht, sodass die beiden Außenelektroden abwechselnd mit den Innenelektrodenschichten elektrisch verbunden sind.

WO 2008/092740 A2 offenbart verschiedene Herstellungsverfahren zur Herstellung eines piezokeramischen Vielschichtaktors. Im Rahmen der Herstellungsverfahren werden Vielschicht-Riegel elektrochemisch oder mechanisch derart bearbeitet, dass sich eine Senken-Struktur ergibt. Die Seitenflächen der Elektroden innerhalb dieser Senken werden elektrisch mit Hilfe von Schlickerguss isoliert, um durch Aufdrucken einer Außenmetallisierung die übrigen Elektroden kontaktieren zu können.

US 5254212 A beschreibt ein Verfahren zur Herstellung eines mehrschichtigen elektro-resistiven Bauteils aus abwechselnd angeordneten Schichten eines elektro-resistiven Materials und Innenelektroden, die bis an Seitenflächen des Bauteiles heranragen. An den Seitenflächen des Bauteils werden an jeder zweiten Innenelektrode Gräben gebildet und mit einem Isolationsmaterial gefüllt.

In DE 102 60 853 A1 wird ein Piezoaktor, beispielsweise zur Betätigung eines mechanischen Bauteils, vorgeschlagen, bei dem ein Mehrschichtaufbau von Piezolagen und dazwischen angeordneten Innenelektroden vorhanden sind. Es ist eine wechselseitige Kontaktierung der Innenelektroden mit Außenelektroden vorhanden, wobei die Bereiche zwischen den Außenelektroden mit einer geeigneten Isolation versehen sind. Im Bereich zwischen den Außenelektroden ist auf die Außenfläche des Piezoaktors eine isolierende Schicht aus einem Material mit nahezu gleichen Eigenschaften wie die Piezolagen aufgebracht.

Es ist Aufgabe der vorliegenden Erfindung, ein Verfahren anzugeben, mit dem ein Piezoaktor mit einem Piezostapel mit möglichst kleinen inaktiven Zonen auf einfachere Weise hergestellt werden kann. Eine weitere Aufgabe der Erfindung besteht darin, einen Piezoaktor anzugeben.

Diese Aufgaben werden gelöst durch ein Verfahren gemäß den Merkmalen des Patentanspruchs 1 sowie einen Piezoaktor gemäß den Merkmalen des Patentanspruchs 12.

Das erfindungsgemäße Verfahren zum Herstellen eines Piezoaktors mit einem Piezostapel und zwei an der Außenseite des Piezostapels angeordneten Außenelektroden basiert auf dem in der DE 10 2006 011 293 A1 beschriebenen Verfahren. Es umfasst die Schritte: Bereitstellen eines vollaktiven Grünstapels aus mehreren abwechselnd aufeinander folgenden Grünfolien und durchgehenden Innenelektrodenschichten, die dazu vorgesehen sind, abwechselnd mit zwei an der Außenseite des aus dem Grünstapel herzustellenden Piezostapels anzuordnenden Außenelektroden elektrisch verbunden und von der jeweiligen anderen Außenelektrode elektrisch isoliert zu sein. Versehen der Außenseite des vollaktiven Grünstapels mit Gräben in Bereichen, in denen die Innenelektrodenschichten von den entsprechenden Außenelektroden elektrisch isoliert sein sollen, so dass die Gräben die Innenelektrodenschichten in diesen Bereichen von der Außenseite des Grünstapels nach Innen verkürzen. Füllen der Gräben mit einem elektrisch isolierenden Schlicker. Weiterverarbeiten des Grünstapels, dessen Gräben mit dem Schlicker gefüllt sind, so dass aus den Grünfolien piezoelektrische Schichten werden und aus dem Grünstapel der Piezostapel wird. Aufbringen der beiden Außenelektroden auf die Außenseite des Piezostapels, so dass die beiden Außenelektroden abwechselnd mit den Innenelektrodenschichten elektrisch verbunden sind. Erfindungsgemäß werden die Gräben mit dem Schlicker durch eines der folgenden Verfahren gefüllt: Siebdrucken, Tauchen, Sprühen oder Vakuuminfiltrieren.

Die erfindungsgemäßen Verfahren zum Füllen der Gräben mit Schlicker weisen den Vorteil auf, dass der Schlicker auf einfache und gleichmäßige Weise auf den mit den Gräben versehenen Grünstapel aufgebracht werden kann.

Ein weiterer Vorteil besteht darin, dass eine hohe Homogenität beim Auffüllen der Gräben mit dem elektrisch isolierenden Schlicker erzielt werden kann. Dies trifft insbesondere bei der Nutzung eines Siebdruckverfahrens zu, bei dem die Menge des Schlickers, welcher in die Gräben eingebracht werden soll, definiert festgelegt werden kann.

Durch die Verfüllung der Gräben mit keramischem Schlicker in einem vollaktiven piezoelektrischen Bauelement entstehen sehr kleine inaktive Bereiche. Diese können derart dimensioniert werden, dass sie nicht größer sind, als es unbedingt für eine gute elektrische Isolierung der Innenelektrodenschichten zur entsprechenden Außenelektroden notwendig ist. Die Gefahr der Entstehung von Polungsrissen kann hierdurch vermindert werden.

Vorteilhafterweise wird das Verdichtungsverhalten der keramischen Partikel im Schlicker an das Verdichtungsverhalten des Piezostapels angepasst. Diesem Vorgehen liegt die Überlegung zu Grunde, dass die Keramik des Grünstapels bei geringeren Temperaturen verdichtet als der keramische Schlicker in den Gräben während des Prozessschritts des Sinterns. Der Grund hierfür ist einerseits, dass der Grünstapel durch eine Lamination der übereinander angeordneten Grünfolien bereits vorverdichtet wurde und damit eine höhere Gründichte aufweist. Zum anderen begünstigt die Diffusion von Silber in den aus AgPd bestehenden Elektroden die Verdichtung bei niedrigeren Temperaturen. Das unterschiedliche Verdichtungsverhalten während des Sinterns kann zu Rissbildungen im Bereich der Gräben führen. Im schlechtesten Fall können hierdurch Kurzschlüsse im kontaktierten Piezostapel verursacht werden. Zur Vermeidung dieser Rissbildung ist vorgesehen, das Schwindverhalten der keramischen Partikel im Schlicker an das Schwindverhalten des Piezostapels anzupassen, welches sich aus der jeweiligen Verdichtung der keramischen Anteile ergibt.

In einer zweckmäßigen Ausgestaltung wird zusätzlich zum Füllen der Gräben mit Schlicker die Oberfläche des Piezostapels mit dem Schlicker zur Ausbildung einer Passivierungsschicht mit dem Schlicker belegt. Hierdurch kann der ansonsten zusätzlich erforderliche Schritt des Aufbringens einer Passivierungsschicht entfallen. Mit den erfindungsgemäß verwendeten Verfahren zum Aufbringen des Schlickers ist dabei sichergestellt, dass die Schichtdicke der Passivierungsschicht gleichmäßig aufgebracht werden kann. Wird der Schlicker durch ein Siebdruckverfahren aufgebracht, so wird der Grünstapel z.B. in einer Werkzeugmaschine gedreht, bis sämtliche zu bearbeitenden Oberflächenseiten mit dem Schlicker belegt und passiviert sind.

Insbesondere ist vorgesehen, dass das Füllen der Gräben und das Aufbringen der Passivierungsschicht auf die Oberfläche des Piezostapels mit dem Schlicker in einem gemeinsamen Verarbeitungsschritt erfolgt.

Nach dem Füllen der Gräben, und optional dem Aufbringen des Schlickers auf die Oberfläche des Piezostapels, wird der Grünstapel in bekannter Weise den Prozessschritten des Entbinderns und Sinterns unterzogen, so dass aus den Grünfolien piezoelektrische Schichten entstehen. Durch das Entbindern und Sintern entsteht aus dem quasi-vollaktiven Grünstapel dann ein quasi-vollaktiver Piezostapel, welcher im Weiteren nach der mechanischen Bearbeitung (z.B. mittels Schleifen) der Seiten mit den Gräben mit den Außenelektroden versehen werden kann.

Das Versehen der Außenseite des vollaktiven Grünstapels mit Gräben erfolgt erfindungsgemäß durch Heißprägen. Während durch das Lasern der Gräben an diesen Stellen die Organik im Grünstapel aufgrund zu hoher Temperaturen verbrennt, wodurch teilweise die Keramik zersetzt werden kann unter Bildung von refraktären Primäroxiden, können die Gräben unter Verwendung des Heißprägeverfahrens im Vergleich dazu mit wesentlich geringeren Temperaturen erzeugt werden. Die Gräben können dabei ohne Bildung von Abbrandmaterial in den Grünstapel eingebracht werden. Da das Einbringen der Gräben in den Grünstapel erfolgt, ist gegenüber dem Einbringen in einen bereits gesinterten Piezostapel eine bessere optische Erkennung der Elektroden gegeben. Bei einem Grünstapel sind die Abmessungen vor dem Prozessschritt des Sinterns ca. 20% größer als nach diesem thermischen Bearbeitungsschritt.

Für das Heißprägeverfahren kann ein Stempel mit einer der Anzahl und Anordnung der zur erzeugenden Gräben entsprechenden Anzahl und Anordnung an Vorsprüngen verwendet werden. Der Abstand der Vorsprünge entspricht dabei dem Abstand zwischen jeder zweiten Innenelektrode des Stapels. Insbesondere ist es mit einem solchen Stempel möglich, in einem einzigen Verfahrensschritt sämtliche Gräben einer Außenseite des Piezostapels zu erzeugen.

Gemäß einer ersten Variante zur Anpassung des Verdichtungsverhaltens der keramischen Partikel im Schlicker an das Verdichtungsverhalten des Piezostapels wird dem Schlicker bei einer thermischen Behandlung (Sintern) ein sein Schwindverhalten beeinflussendes Mittel beigemischt. Als das Schwindverhalten des Schlickers beeinflussendes Mittel kann Ag, AgO oder PbO verwendet werden. Das das Schwindverhalten des Schlickers beeinflussende Mittel nimmt insbesondere 0,05 bis 1,00 Gewichtsprozent des Schlickers ein, so dass von einer "Dotierung" des keramischen Pulvers gesprochen werden kann.

In einer zweiten Variante wird die Sinteraktivität der keramischen Partikel in dem Schlicker durch eine Reduktion der Korn- oder Primärpartikelgrößen angehoben.

In einer dritten Variante wird der Grünstapel, dessen Gräben mit dem Schlicker (ohne ein das Schwindverhalten beeinflussendes Mittel) gefüllt sind, in einem Flüssigkeitsbad unter Druck gesetzt, um den in den Gräben angeordneten Schlicker zu verpressen. Die Prozessführung erfolgt dabei vorzugsweise derart, dass ein isostatisches Verpressen des keramischen Schlickers erfolgt und eine annähernd identische Gründichte zu den übereinander angeordneten Grünfolien (d.h. dem Grünstapel) erzielt ist. Durch dieses Vorgehen erfolgt somit eine nachträgliche Verdichtung des in den Gräben befindlichen Schlickers.

Diese oben aufgeführten Alternativen können auch (beliebig) miteinander kombiniert werden, um das Schwindverhalten des Schlickers in den Gräben an das Schwindverhalten des Grünstapels anzupassen.

Gemäß einer weiteren zweckmäßigen Ausgestaltung erfolgt das Füllen der Gräben mit dem Schlicker in mehreren Schritten, wodurch eine ebene Oberfläche des Grünstapels im Bereich der aufzubringenden Außenelektroden erzielt wird.

Die Erfindung schafft weiterhin einen Piezoaktor mit einem Piezostapel und zwei an der Außenseite des Piezostapels angeordneten Außenelektroden, der gemäß dem oben beschriebenen Verfahren hergestellt wurde.

Die Erfindung wird nachfolgend näher anhand eines Ausführungsbeispiels erläutert. Es zeigen:
- Fig. 1a) und 1b): einen erfindungsgemäßen Piezoaktor gemäß einem ersten Ausführungsbeispiel, jeweils in einer geschnittenen Seitenansicht,
- Fig. 1c): den erfindungsgemäßen Piezoaktor gemäß Fig. 1a) und 1b) in einer geschnittenen Draufsicht,
- Fig. 2a) und 2b): einen erfindungsgemäßen Piezoaktor gemäß einem zweiten Ausführungsbeispiel, jeweils in einer geschnittenen Seitenansicht, und
- Fig. 2c): den erfindungsgemäßen Piezoaktor gemäß Fig. 2a) und 2b) in einer geschnittenen Draufsicht.

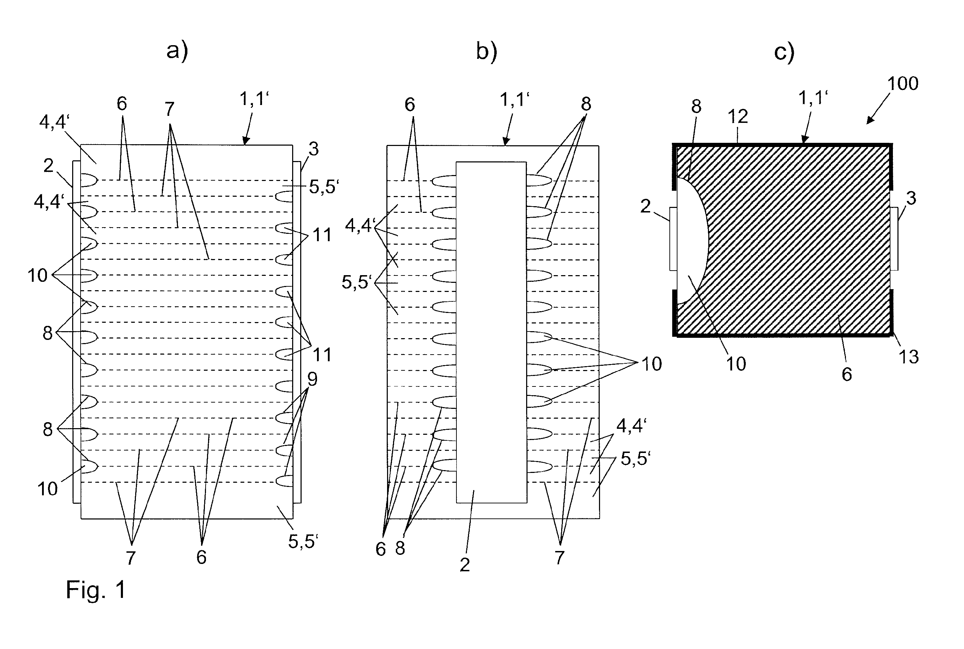

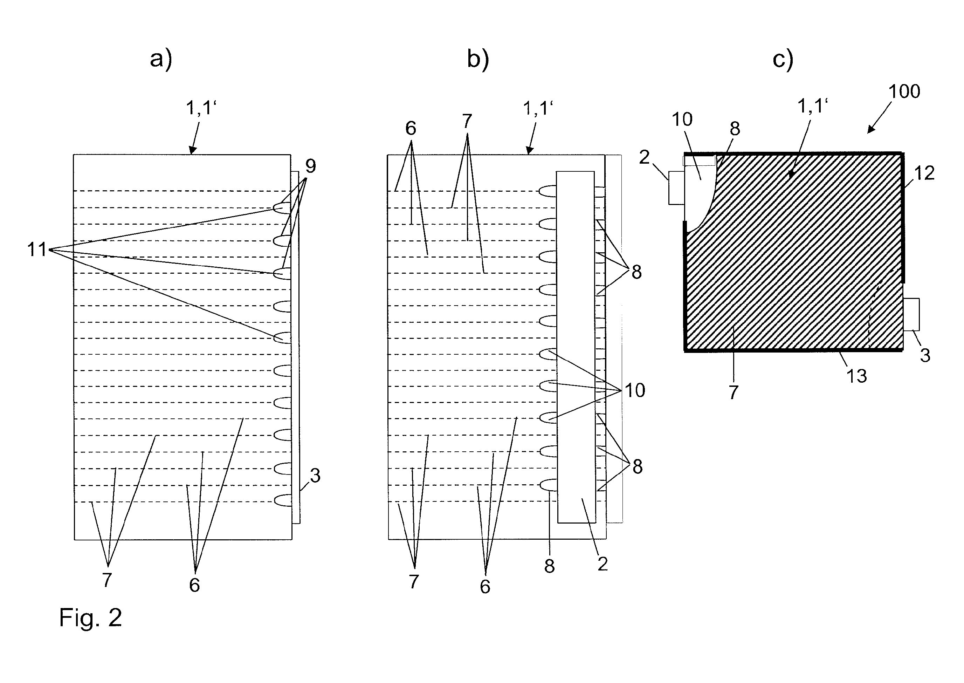

Ausgangspunkt für die in den Figuren 1 und 2 dargestellten Piezoaktoren 100 ist im Falle der vorliegenden Ausführungsbeispiele ein in der Draufsicht jeweils quaderförmig ausgeführter vollaktiver Grünstapel 1', der mehrere Grünfolien 4', 5' und dazwischen angeordnete Innenelektrodenschichten 6, 7 aufweist (vgl. Fig. 1c) und 2c)). Der Grünstapel 1' ist in allgemein bekannter Weise durch das abwechselnde Stapeln einer Innenelektrodenschicht und einer Grünfolie erzeugt. Die Grünfolien 4', 5' umfassen ein piezokeramisches Material, beispielsweise Blei-Zirkonat-Titanat. Bei den Innenelektrodenschichten 6, 7 handelt es sich beispielsweise um elektrisch leitfähige Metallschichten, die den Grünstapel 1' durchgehend durchsetzen, also bis an die Außenseiten des Grünstapels 1' durchgehend ausgebildet sind, so dass der Grünstapel 1' zunächst keine inaktiven, sondern lediglich aktive Zonen hat. Die Innenelektrodenschichten 6, 7 sind dazu vorgesehen, abwechselnd mit zwei an der Außenseite eines aus dem Grünstapel 1' herzustellenden Piezostapels 1 anzuordnenden Außenelektroden 2, 3 elektrisch verbunden und von der jeweiligen anderen Außenelektrode 3, 2 elektrisch isoliert zu sein.

Zur Herstellung des Piezoaktors 100 werden auf wenigstens einer Außenseite des Grünstapels 1' Gräben 8, 9 vorgesehen, so dass aus dem vollaktiven Grünstapel 1' ein inaktive Zonen aufweisender Stapel entsteht. In den beiden, in den Figuren 1 und 2 dargestellten, Ausführungsbeispielen sind die Gräben 8, 9 auf gegenüberliegenden Außenseiten des Grünstapels 1' vorgesehen. Während in dem Ausführungsbeispiel der Fig. 1 die jeweiligen Gräben bezüglich ihrer Außenseite zentral angeordnet sind (vgl. insbesondere die Schnittdarstellung der Fig. 1c)), sind die Gräben 8, 9 in dem in Fig. 2 gezeigten Ausführungsbeispiel im Bereich von schräg gegenüberliegenden Seitenkanten der gegenüberliegenden Außenflächen angeordnet (vgl. Fig. 2c)).

Eine jeweilige Außenseite des Grünstapels 1' wird derart mit den Gräben 8 bzw. 9 versehen, dass jede Innenelektrode 6 durch die Gräben 8 in das Innere des Grünstapels 1' zurückversetzt ist und die übrigen Innenelektroden 7 vollständig an die betreffende Außenseite herangeführt bleiben. In entsprechender Weise sind die Gräben 9 auf der anderen Außenseite derart ausgeführt, dass jeweils die Innenelektroden 7 in das Innere des Grünstapels 1' zurückversetzt sind, während die Innenelektroden 6 an diese Außenseite herangeführt sind. Im Falle der gezeigten Ausführungsbeispiele in den Figuren 1 und 2 sind somit die Gräben 8 den Innenelektroden 6 und die Gräben 9 den Innenelektroden 7 zugeordnet.

Erfindungsgemäß werden die Gräben 8, 9 durch Heißprägen erzeugt. Hierzu wird der Grünstapel 1' auf der betreffenden Außenseite mit einem Stempel bei erhöhter Temperatur mit Druck beaufschlagt (T > T_{g} Glasübergangstemperatur des Polymerbinders im Grünstapel, typischweise 20-200°C). Der Stempel weist eine der Anzahl und Anordnung der zu erzeugenden Gräben 8, 9 entsprechenden Anzahl und Anordnung an Vorsprüngen auf, wodurch im Bereich der Vorsprünge der Grünstapel 1' zur Ausbildung der Gräben verformt wird. Der Abstand der Vorsprünge entspricht dabei dem der Abstände der Innenelektrodenschichten 6 bzw. 7. Mit Hilfe des Heißprägeverfahrens können die Gräben unter (im Vergleich zum Lasern nur leicht erhöhter) Temperatur und Druck in den Grünstapel 1' eingebracht werden. Dabei werden die Gräben ohne Bildung von Abbrandmaterial eingebracht. Die Anwendung des Heißprägeverfahrens bei vorliegendem Grünstapel 1' ermöglicht aufgrund der größeren Abmessungen des Grünstapels 1' gegenüber dem bereits gesinterten Piezostapel 1 eine bessere optische Erkennung der Elektroden, so dass das Verfahren auf einfache und zuverlässige Weise durchgeführt werden kann.

Nicht-erfindungsgemäß könnte das Einbringen der Gräben auch durch Laserablation, Sägen mit (Vielfach-)Kreissägeblättern, Mikrofräsen, Räumen, Ultraschall-Erodieren sowie Wasser-, Sand- oder CO₂-Strahlen erfolgen. Anschließend werden die Gräben 8, 9 mit elektrisch isolierenden, keramischem Schlicker 10 bzw. 11 befüllt. Das Füllen der Gräben 8, 9 mit dem Schlicker 10, 11 erfolgt erfindungsgemäß durch Siebdrucken, Tauchen, Sprühen oder Vakuuminfiltrieren. Dabei wird vorzugsweise gleichzeitig die Oberfläche des Grünstapels 1' zur Ausbildung einer Passivierungsschicht mit dem Schlicker belegt. Die Verwendung eines keramischen Schlickers als Füllmaterial für die Gräben ermöglicht die Herstellung eines Piezoaktors 100 mit einem homogenen Piezostapel 1, bei dem zwischen den Schlicker-gefüllten Gräben und Grünfolien 4', 5' nach dem Sintern keine Trennlinien entstehen. Hierdurch können Polungsrisse vermieden werden.

Als besonders bevorzugt hat sich das Aufbringen des Schlickers durch ein Siebdruckverfahren herausgestellt, da sich hierdurch homogene Schichtdicken sowohl bezüglich der mit Schlicker gefüllten Gräben 8, 9 als auch der Passivierungsschichten 12, 13 erzielen lassen. Hierzu wird der zu verarbeitende Grünstapel 1' in einer Werkzeugmaschine entsprechend gedreht, so dass der Siebdruck auf allen Außenseiten des Stapels realisiert werden kann.

Nach dem Einbringen des Schlickers 10, 11 in die Gräben 8, 9, sowie der optionalen Erzeugung der Passivierungsschichten 12, 13, werden die Prozessschritte Entbindern, Sintern und mechanische Bearbeitung (z.B. Schleifen) durchgeführt, wodurch der Piezostapel 1 entsteht. Anschließend werden die beiden Außenelektroden 2, 3 auf die jeweiligen Außenseiten des Piezostapels 1 aufgebracht, so dass die beiden Außenelektroden 2 bzw. 3 mit den Innenelektrodenschichten 6 bzw. 7 elektrisch verbunden sind.

Die Außenelektroden 2, 3 werden als Außenmetallisierung längs der betreffenden Außenseiten des Piezostapels 1 aufgetragen. Dabei wird die Außenelektrode 2 mit den Innenelektrodenschichten 7 verbunden. Die Außenelektrode 3 wird mit den Innenelektrodenschichten 6 elektrisch verbunden. Die Außenelektroden 2, 3 sind jeweils schmaler als die Gräben 8, 9 breit sind und verlaufen über die mit dem Schlicker 10, 11 gefüllten Gräben 8, 9, so dass die Außenelektroden 2, 3 von den Innenelektrodenschichten 6, 7 elektrisch isoliert sind. Die Tiefe, Breite und Höhe der Gräben 8, 9 ist derart gewählt, dass sie in Verbindung mit dem elektrisch isolierenden Schlicker 10, 11 eine zuverlässige elektrische Isolierung der Innenelektroden 6 bzw. 7 von den Außenelektroden 3 bzw. 2 gewährleisten.

Sofern die Außenflächen, auf denen die Gräben erzeugt wurden, mit der Passivierungsschicht versehen sind, werden diese einer vorherigen mechanischen Bearbeitung (z.B. Schleifen) unterzogen, um die an die betreffende Außenseite grenzenden Innenelektrodenschichten 6, 7 freizulegen. Erst anschließend erfolgt die Erzeugung der Außenelektroden 2, 3. Die Keramik des Grünstapels 1', d.h. der Grünfolien 4' und 5' verdichtet beim Sintern bei niedrigeren Temperaturen als die keramischen Partikel in dem Schlicker in den Gräben 8, 9. Das liegt zum einen daran, dass der Grünstapel 1' durch die Lamination der übereinander geschichteten Grünfolien 4', 5' bereits vorgedichtet wurde und damit eine höhere Gründichte aufweist. Zum anderen begünstigt die Silberdiffusion aus den aus AgPd bestehenden Elektroden die Verdichtung des Grünstapels 1' bei niedrigeren Temperaturen. Das unterschiedliche Verdichtungsverhalten kann zu Rissbildungen des Schlickers in den Gräben führen und somit Kurzschlüsse im fertig gestellten Piezostapel verursachen.

Verdichten die keramischen Anteile im Grünstapel 1' und im Schlicker hingegen bei annähernd gleichen Temperaturen, so kann die Rissbildung der Keramik in den Gräben vermieden werden. Zur Vermeidung der Rissbildung wird daher das Verdichtungsverhalten der keramischen Partikel im Schlicker an das Verdichtungsverhalten der Keramik im Grünstapel 1' angepasst. Dies kann durch die Zugabe von Silber, Silberoxid oder Bleioxid zum Schlicker erfolgen. Es ist dabei ausreichend, wenn die das Schwindverhalten beeinflussenden Mittel in einem Umfang von 0,05 bis 1,00 Gewichts-% zugegeben sind. Alternativ kann die Sinteraktivität der keramischen Partikel angehoben werden, indem auf feinere Primärpartikel- oder Korngrößen zurückgegriffen wird.

Weiter alternativ kann eine nachträgliche Verdichtung des in den Gräben befindlichen Schlickers nach dessen Trocknung erfolgen. Hierzu kann beispielsweise ein isostatischer Pressvorgang in einem Flüssigkeitsbad durchgeführt werden. Im Ergebnis führen die beschriebenen Varianten zu einer dem Grünstapel 1' besser angepassten Gründichte des Schlickers in den Gräben, wodurch das Schwindverhalten aneinander angepasst und die Sinteraktivität erhöht ist. In diesem Zusammenhang ist es vorteilhaft, wenn das Einbringen des Schlickers in die Gräben 8, 9 in mehreren Teilschritten erfolgt, um eine ebene Oberfläche der Außenseiten des Stapels zu erhalten.

Alternativ kann auch eine Kombination vorher genannter Verfahren zum Einsatz gebracht werden, um das Schwindverhalten des Schlickers in den Gräben an das Schwindverhalten des Grünstapels anzupassen.

## Patentansprüche

1. Verfahren zum Herstellen eines Piezoaktors (100) mit einem Piezostapel (1) und zwei an der Außenseite des Piezostapels (1) angeordneten Außenelektroden (2, 3), mit den Schritten:
- Bereitstellen eines vollaktiven Grünstapels (1') aus mehreren abwechselnd aufeinander folgenden Grünfolien (4', 5') und durchgehenden Innenelektrodenschichten (6, 7), die dazu vorgesehen sind, abwechselnd mit je eine der zwei an der Außenseite des aus dem Grünstapel (1') herzustellenden Piezostapels (1) anzuordnenden Außenelektroden (2, 3) elektrisch verbunden und von der jeweiligen anderen Außenelektrode (2, 3) elektrisch isoliert zu sein,
- Versehen der Außenseite des vollaktiven Grünstapels (1') mit Gräben (8, 9) in Bereichen, in denen die Innenelektrodenschichten (6, 7) von den entsprechenden Außenelektroden (2, 3) elektrisch isoliert sein sollen, so dass die Gräben (8, 9) die Innenelektrodenschichten (6, 7) in diesen Bereichen von der Außenseite des Grünstapels (1') nach innen verkürzen,
- Füllen der Gräben (8, 9) mit einem elektrisch isolierenden Schlicker (10, 11),
- Weiterverarbeiten des Grünstapels (1'), dessen Gräben (8, 9) mit dem Schlicker (10, 11) gefüllt sind, so dass aus den Grünfolien (4', 5') piezoelektrische Schichten (4, 5) werden und aus dem Grünstapel (1') der Piezostapel (1) wird,
- Aufbringen der beiden Außenelektroden (2, 3) auf die Außenseite des Piezostapels (1), so dass die beiden Außenelektroden (2, 3) abwechselnd mit den Innenelektrodenschichten (6, 7) elektrisch verbunden sind,
wobei die Gräben (8, 9) mit dem Schlicker (10, 11) durch eines der folgenden Verfahren gefüllt werden: Siebdrucken, Tauchen, Sprühen oder Vakuuminfiltrieren,
**dadurch gekennzeichnet, dass** das Versehen der Außenseite des vollaktiven Grünstapels (1') mit Gräben (8, 9) durch Heißprägen erfolgt.

2. Verfahren nach Anspruch 1, **dadurch gekennzeichnet, dass** zusätzlich zum Füllen der Gräben (8, 9) mit dem Schlicker (10, 11) die Oberfläche des Piezostapels (1) mit dem Schlicker (10, 11) zur Ausbildung einer Passivierungsschicht (12, 13) mit dem Schlicker (10, 11) belegt wird.

3. Verfahren nach Anspruch 2, **dadurch gekennzeichnet, dass** das Füllen der Gräben (8, 9) und das Aufbringen der Passivierungsschicht (12, 13) auf die Oberfläche des Piezostapels (1) mit dem Schlicker (10, 11) in einem gemeinsamen Verarbeitungsschritt erfolgt.

4. Verfahren nach einem der vorhergehenden Ansprüche, **dadurch gekennzeichnet, dass** ein Stempel mit einer der Anzahl und Anordnung der zu erzeugenden Gräben (8, 9) entsprechenden Anzahl und Anordnung an Vorsprüngen verwendet wird.

5. Verfahren nach einem der vorhergehenden Ansprüche, **dadurch gekennzeichnet, dass** das Verdichtungsverhalten der keramischen Partikel im Schlicker (10, 11) an das Verdichtungsverhalten des Piezostapels (1) angepasst wird.

6. Verfahren nach Anspruch 5, **dadurch gekennzeichnet, dass** dem Schlicker (10, 11) bei einer thermischen Behandlung ein sein Schwindverhalten beeinflussendes Mittel beigemischt wird.

7. Verfahren nach Anspruch 6, **dadurch gekennzeichnet, dass** als das Schwindverhalten des Schlickers beeinflussendes Mittel Ag, AgO oder PbO verwendet wird.

8. Verfahren nach Anspruch 6 oder 7, **dadurch gekennzeichnet, dass** das das Schwindverhalten des Schlickers beeinflussende Mittel 0,05 bis 1,00 Gewichts-% des Schlickers einnimmt.

9. Verfahren nach einem der Ansprüche 5 bis 8, **dadurch gekennzeichnet, dass** die Sinteraktivität der keramischen Partikel in dem Schlicker (10, 11) durch eine Reduktion der Korn- oder Primärpartikelgrößen angehoben wird.

10. Verfahren nach einem der Ansprüche 5 bis 9, **dadurch gekennzeichnet, dass** der Grünstapel (1'), dessen Gräben (8, 9) mit dem Schlicker (10, 11) gefüllt sind, in einem Flüssigkeitsbad unter Druck gesetzt wird, um den in den Gräben (8, 9) angeordneten Schlicker (10, 11) zu verpressen.

11. Verfahren nach einem der vorhergehenden Ansprüche, **dadurch gekennzeichnet, dass** das Füllen der Gräben (8, 9) mit dem Schlicker (10, 11) in mehreren Schritten erfolgt.

12. Piezoaktor mit einem Piezostapel (1) und zwei an der Außenseite des Piezostapels (1) angeordneten Außenelektroden (2, 3), der gemäß einem der vorhergehenden Ansprüche hergestellt wurde.

## Claims

1. Method for producing a piezo actuator (100) with a piezo stack (1) and two outer electrodes (2, 3) arranged on the outer side of the piezo stack (1), comprising the steps:
- providing a fully active green stack (1') comprising a plurality of alternately successive green films (4', 5') and continuous inner electrode layers (6, 7), which are provided for the purpose of alternately being connected electrically to one of the two outer electrodes (2, 3) to be arranged on the outer side of the piezo stack (1) which is to be produced from the green stack (1') and being insulated electrically from the respective other outer electrode (2, 3),
- providing the outer side of the fully active green stack (1') with trenches (8, 9) in areas in which the inner electrode layers (6, 7) are intended to be insulated electrically from the corresponding outer electrodes (2, 3), so that the trenches (8, 9) shorten the inner electrode layers (6, 7) in these areas from the outer side of the green stack (1') to the inside,
- filling the trenches (8, 9) with an electrically insulating slurry (10, 11),
- further processing the green stack (1'), the trenches (8, 9) of which are filled with the slurry (10, 11), so that the green films (4', 5') become piezo-electric layers (4, 5) and the green stack (1') becomes the piezo stack (1),
- applying the two outer electrodes (2, 3) to the outer side of the piezo stack (1), so that the two outer electrodes (2, 3) are alternately connected electrically to the inner electrode layers (6, 7),
wherein
the trenches (8, 9) are filled with the slurry (10, 11) by means of one of the following methods: screen printing, immersion, spraying or vacuum infiltration, **characterized in that** the outer side of the fully active green stack (1') is provided with trenches (8, 9) by hot embossing.

2. Method according to Claim 1, **characterized in that** in addition to filling the trenches (8, 9) with the slurry (10, 11), the surface of the piezo stack (1) is covered with the slurry (10, 11) in order to form a passivation layer (12, 13) with the slurry (10, 11).

3. Method according to Claim 2, **characterized in that** the filling of the trenches (8, 9) and the application of the passivation layer (12, 13) to the surface of the piezo stack (1) with the slurry (10, 11) are carried out in a common processing step.

4. Method according to one of the preceding claims, **characterized in that** a stamp having a number and arrangement of protrusions corresponding to the number and arrangement of the trenches (8, 9) to be produced is used.

5. Method according to one of the preceding claims, **characterized in that** the compaction behaviour of the ceramic particles in the slurry (10, 11) is matched to the compaction behaviour of the piezo stack (1).

6. Method according to Claim 5, **characterized in that** an agent influencing the shrinkage behaviour of the slurry (10, 11) is added thereto during a thermal treatment.

7. Method according to Claim 6, **characterized in that** Ag, AgO or PbO is used as an agent influencing the shrinkage behaviour of the slurry.

8. Method according to Claim 6 or 7, **characterized in that** the agent influencing the shrinkage behaviour of the slurry assumes 0.05 to 1.00% by weight of the slurry.

9. Method according to one of Claims 5 to 8, **characterized in that** the sintering activity of the ceramic particles in the slurry (10, 11) is enhanced by means of a reduction in the grain or primary particle sizes.

10. Method according to one of Claims 5 to 9, **characterized in that** the green stack (1'), the trenches (8, 9) of which are filled with the slurry (10, 11), is placed under pressure in a liquid bath, in order to compress the slurry (10, 11) arranged in the trenches (8, 9).

11. Method according to one of the preceding claims, **characterized in that** the filling of the trenches (8, 9) with the slurry (10, 11) is carried out in a plurality of steps.

12. Piezo actuator with a piezo stack (1) and two outer electrodes (2, 3) arranged on the outer side of the piezo stack (1), which has been produced in accordance with one of the preceding claims.

## Revendications

1. Procédé de fabrication d'un actionneur piézo-électrique (100) avec une piézo-pile (1) et deux électrodes externes (2, 3) disposées à l'extérieur de la piézo-pile, comprenant les étapes suivantes :
- mise à disposition d'une pile verte entièrement active (1') constituée en alternance de plusieurs films verts successifs (4', 5') et de couches d'électrodes internes continues (6, 7) qui sont conçues pour être reliées électriquement en alternance chacune avec une des deux électrodes externes (2, 3) à disposer à l'extérieur de la piézo-pile (1) à fabriquer à partir de la pile verte (1') et pour être isolées électriquement de l'autre électrode externe (2, 3),
- équipement de l'extérieur de la pile verte entièrement active (1') avec des creux (8, 9) dans des zones dans lesquelles les couches d'électrodes internes (6, 7) doivent être isolées électriquement des électrodes externes (2, 3) correspondantes, de façon à ce que les creux (8, 9) raccourcissent les couches d'électrodes internes respectives (6, 7) dans ces zones du bord externe de la pile verte (1') vers l'intérieur,
- remplissage des creux (8, 9) avec une barbotine (10, 11) électriquement isolante,
- transformation de la pile verte (1'), dont les creux (8, 9) sont remplis de barbotine (10, 11), de façon à ce que les films verts (4', 5') deviennent des couches piézo-électriques (4, 5) et le pile verte (1') devienne la piézo-pile (1),
- application des deux électrodes externes (2, 3) sur les bords externes de la piézo-pile (1), de façon à ce que les deux électrodes externes (2, 3) soient reliées électriquement en alternance avec les électrodes internes (6, 7),
les creux (8, 9) étant remplis de barbotine (10, 11) à l'aide d'un des procédés suivants : sérigraphie, immersion, pulvérisation ou infiltration sous vide, **caractérisé en ce que** le garnissage des bords externes de la pile verte entièrement active (1') avec des creux (8, 9) a lieu par estampage à chaud.

2. Procédé selon la revendication 1, **caractérisé en ce que**, en plus du remplissage des creux (8, 9) avec la barbotine (10, 11), la surface de la piézo-pile (1) est recouverte de barbotine (10, 11) afin de former une couche de passivation (12, 13) avec la barbotine (10, 11).

3. Procédé selon la revendication 2, **caractérisé en ce que** le remplissage des creux (8, 9) et l'application de la couche de passivation (12, 13) sur la surface de la piézo-pile (1) avec la barbotine (10, 11) ont lieu en une étape commune de transformation.

4. Procédé selon l'une des revendications précédentes, **caractérisé en ce qu'**un marquage avec un nombre et une disposition de saillies correspondant au nombre et à la disposition des creux (8, 9) à réaliser est utilisé.

5. Procédé selon l'une des revendications précédentes, **caractérisé en ce que** le comportement à la compression des particules céramiques dans la barbotine (10, 11) est adapté au comportement à la compression de la piézo-pile (1).

6. Procédé selon la revendication 5, **caractérisé en ce qu'**un produit est ajouté à la barbotine (10, 11) afin d'influencer son comportement de retrait lors d'un traitement thermique.

7. Procédé selon la revendication 6, **caractérisé en ce que** le produit utilisé pour influencer le comportement de retrait de la barbotine est : Ag, AgO ou PbO.

8. Procédé selon la revendication 6 ou 7 **caractérisé en ce que** le produit influençant le comportement de retrait de la barbotine constitue 0,05 à 1,00 % en poids de la barbotine.

9. Procédé selon l'une des revendications 5 à 8, **caractérisé en ce que** l'activité de frittage des particules céramiques dans la barbotine (10, 11) est augmentée par une réduction des tailles de grains ou de particules primaires.

10. Procédé selon l'une des revendications 5 à 9, **caractérisé en ce que** la pile verte (1'), dont les creux (8, 9) sont remplis de barbotine (10, 11), est placée dans un bain de liquide sous pression afin de comprimer la barbotine (10, 11) disposée dans les creux (8, 9).

11. Procédé selon l'une des revendications précédentes, **caractérisé en ce que** le remplissage des creux (8, 9) avec la barbotine (10, 11) s'effectue en plusieurs étapes.

12. Actionneur piézo-électrique avec une piézo-pile (1) et deux électrodes externes (2, 3) disposées à l'extérieur de la piézo-pile (1), qui a été fabriqué selon l'une des revendications précédentes.
